# EUROPEAN PATENT SPECIFICATION

(11) **EP 1 437 775 B1**
(45) Date of publication and mention of the grant of the patent: **18.08.2010**
(21) Application number: 03257431.1
(22) Date of filing: 25.11.2003
(51) Int. Cl.: H01L 21/28, H01L 29/423

(54) **Method of manufacturing a semiconductor memory device with nano dots**
Herstellungsverfahren eines Halbleiterspeichers mit Nanodots
Procédé de fabrication d'un dispositif de mémoire à semi-conducteur avec des nanopoints

(30) Priority: 23.12.2002 KR 2002082387
(43) Date of publication of application: 14.07.2004
(73) Proprietor: SAMSUNG ELECTRONICS CO., LTD., Suwon-city, Kyungki-do 442-742 (KR)
(72) Inventor: Kim, In-sook, Haman-gun, Gyeongsangnam-do, (KR); Seo, Sun-ae, Seoul National University, Gawanak-gu, Seoul (KR); Yoo, In-kyeong, Sinbong-dong, Yongin-si, Gyeonggi-do (KR); Jeong, Soo-hwan, Yongin-si, Gyeonggi-do (KR)
(74) Representative: Anderson, James Edward George

(56) References cited:
- JIANYU LIANG ET AL: "Nonlithographic Fabrication of Lateral Superlattices for Nanometric Electromagnetic-Optic Applications" IEEE JOURNAL OF SELECTED TOPICS IN QUANTUM ELECTRONICS, IEEE SERVICE CENTER, PISCATAWAY, NJ, US, vol. 8, no. 5, September 2002 (2002-09), XP011066199 ISSN: 1077-260X
- DMITRI ROUTKEVITCH ET AL: "Nonlithographic Nano-Wire Arrays: Fabrication, Physics, and Device Applications" IEEE TRANSACTIONS ON ELECTRON DEVICES, IEEE SERVICE CENTER, PISACATAWAY, NJ, US, vol. 43, no. 10, October 1996 (1996-10), XP011015942 ISSN: 0018-9383
- CROUSE D ET AL: "Self-ordered pore structure of anodized aluminum on silicon and pattern transfer" APPLIED PHYSICS LETTERS, AIP, AMERICAN INSTITUTE OF PHYSICS, MELVILLE, NY, US, vol. 76, no. 1, 3 January 2000 (2000-01-03), pages 49-51, XP012024738 ISSN: 0003-6951
- MURAKAMI Y ET AL: "Al dot hexagonal array formation using anodic oxidation and selective etching" MICROPROCESSES AND NANOTECHNOLOGY CONFERENCE, 2000 INTERNATIONAL JULY 11-13, 2000, PISCATAWAY, NJ, USA,IEEE, 11 July 2000 (2000-07-11), pages 178-179, XP010513549 ISBN: 4-89114-004-6
- PATENT ABSTRACTS OF JAPAN vol. 2003, no. 03, 5 May 2003 (2003-05-05) -& JP 2002 332578 A (CANON INC), 22 November 2002 (2002-11-22)

## Description

The present invention relates to a method of manufacturing memory with nano dots, and more particularly, to a method of manufacturing memory with nano dots using self-alignment.

Much attention and efforts are now being paid to the development of nano-scale devices to be included in an apparatus such as memory, laser diodes (LDs), photo diodes, transistors, far-ultraviolet detectors, solar batteries, and optical modulators. The number of electrons captured in a nanodevice depends on the sizes of nano dots. Nanodevices can be driven with a smaller amount of electrons than conventional devices, thereby lowering a threshold current. Therefore, a nanodevice can be driven by low voltage and induce a high output with low voltage.

Conventionally, nano dots are made by forming an atomic nucleus with Si or Si₃N₄, using a general deposition method such as low-pressure chemical vapor deposition (LPCVD), or by spraying nano particles over a substrate. However, this method is disadvantageous in that it is difficult to appropriately adjust the sizes of nano particles, and obtain a uniform distribution of nano dots even if nano particles having the same sizes are selected and sprayed onto the substrate.

The information communication technology of today requires techniques of storing, processing, and transmitting a large capacity of tera-class information at a high speed. In particular, the size of a nano dot needs to be reduced to several nm in order to store a large capacity of information and a technique of forming a uniform distribution of nano dots is required to realize high-performance memory.

Jianyu Liang et al: "Nonlithographic fabrication of lateral superlattices for nanometric electromagnetic-optic applications", IEEE Journal of Selected Topics in Quantum Electronics, vol. 8, no. 5, September 2002, discloses methods of forming nanostructures using an Al template.

The present invention is defined by claim 1 and provides a method of manufacturing memory with several-nm nano dots in order to realize a large capacity of memory.

According to an aspect of the present invention, there is provided a method of fabricating a charge-storage memory transistor having nano dots, comprising: (a) sequentially depositing a first insulating layer, a charge storage layer, a sacrificial layer, and a metal layer on a substrate in which source and drain electrodes are formed; (b) forming a plurality of holes on the resultant structure by anodizing the metal layer and oxidizing the sacrificial layer which is exposed through the holes; (c) patterning the charge storage layer to have nano dots by removing the oxidized metal layer, etching the sacrificial layer and the charge storage layer using the oxidized sacrificial layer as a mask; and (d) removing the oxidized sacrificial layer, depositing a second insulating layer and a gate electrode on the patterned charge storage layer, and patterning the first insulating layer, the charge storage layer, the second insulating layer, and the gate electrode to a predetermined shape.

The charge storage layer is preferably formed of a material selected from a group consisting of Si, Si₃N₄, and Al₂O₃.

It is preferable that the sacrificial layer is formed of Ta and the metal layer is formed of Al or Al alloy.

The first and second insulating layers are preferably formed of Si₃N₄, and Al₂O₃.

It is preferable that during (a), the first insulating layer, the charge storage layer, the sacrificial layer, the metal layer, and the second insulating layer are deposited using chemical vapor deposition (CVD), sputtering, or evaporation.

It is preferable that during (c), the charge storage layer is patterned to have a dot array structure in which a plurality of cylinders are arranged to form a honeycomb structure.

The above and other advantages of the present invention will become more apparent by describing in detail preferred embodiments thereof with reference to the attached drawings in which:
FIGS. 1A through 1K are cross-sectional views illustrating a method of fabricating memory according to a preferred embodiment of the present invention; and
FIG. 2 is a photograph showing nano dots formed in memory that is fabricated using a memory fabrication method according to the present invention, taken by a scanning electron microscope (SEM).

A method of fabricating memory with nano dots according to a preferred embodiment of the present invention will now be described with the accompanying drawings.

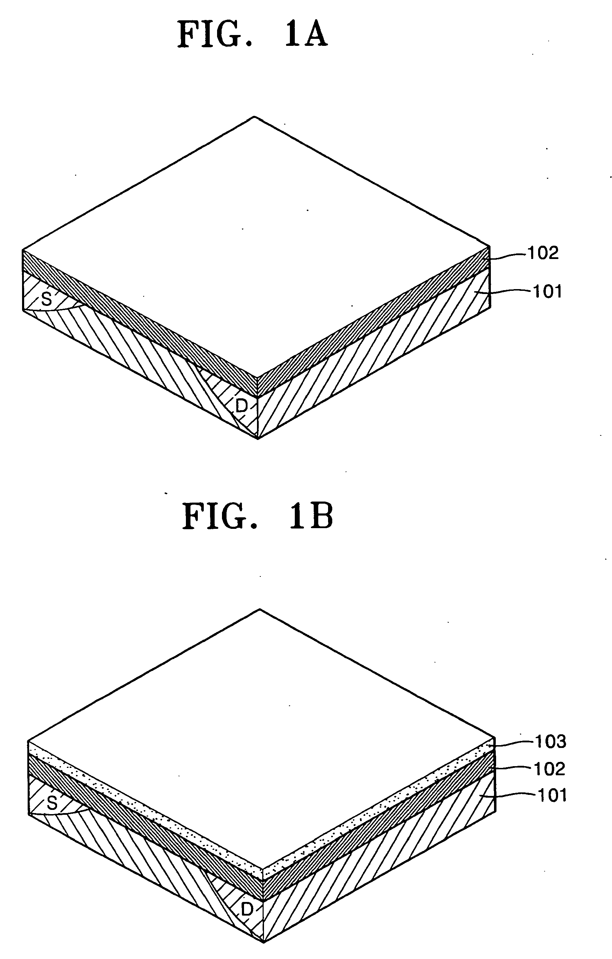

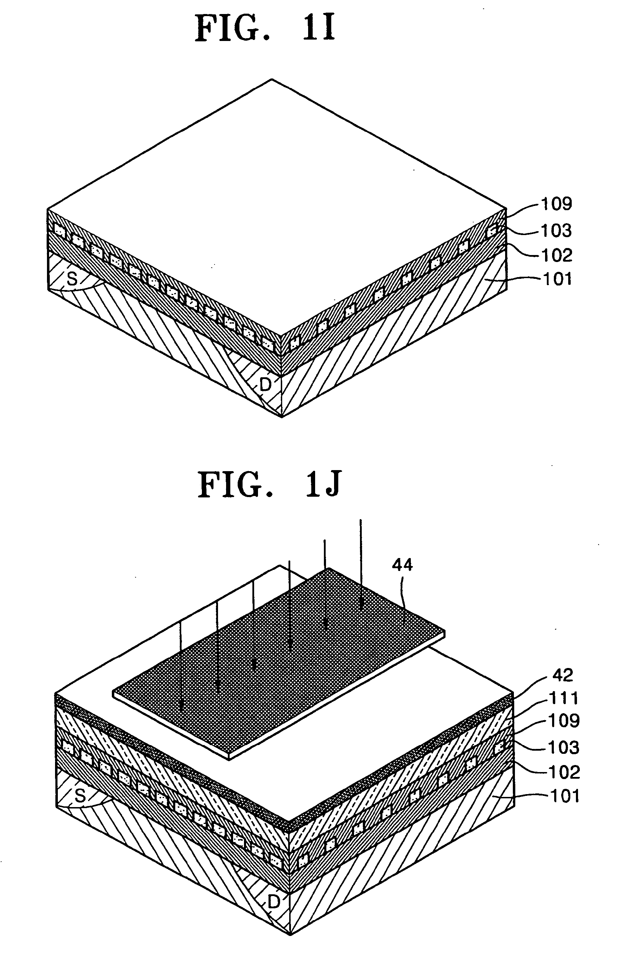

FIGS. 1A through 1K are cross-sectional views illustrating a method of fabricating memory with nano dots according to a preferred embodiment of the present invention. The method includes steps of forming nano dots (see FIGS. 1A through 1H) and fabricating memory with nano dots to complete a transistor structure (see FIGS. 1I through 1K).

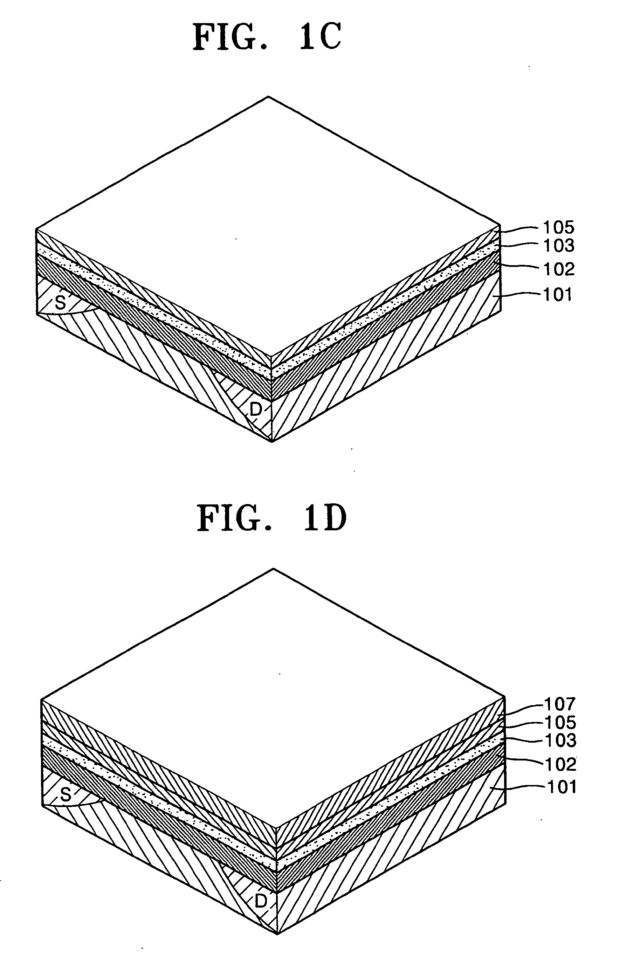

More specifically, as shown in FIG. 1A, a first insulating layer 102 is deposited on a substrate 101 in which source and drain electrodes *S* and *D* are formed. Next, a charge storage layer 103 is deposited on the first insulating layer 102 using a charge storage material such as Si, Si₃N₄, or Al₂O₃, as shown in FIG. 1B. Referring to FIG. 1C, a sacrificial layer 105 is deposited on the charge storage layer 103 using metal such as Ta. Next, referring to FIG. 1D, a metal layer 107 is deposited on the sacrificial layer 105 using metal such as Al. The first insulating layer 102, the charge storage layer 103, the sacrificial layer 105, and the metal layer 107 are formed using a thin film deposition method such as chemical vapor deposition (CVD), sputtering, or evaporation.

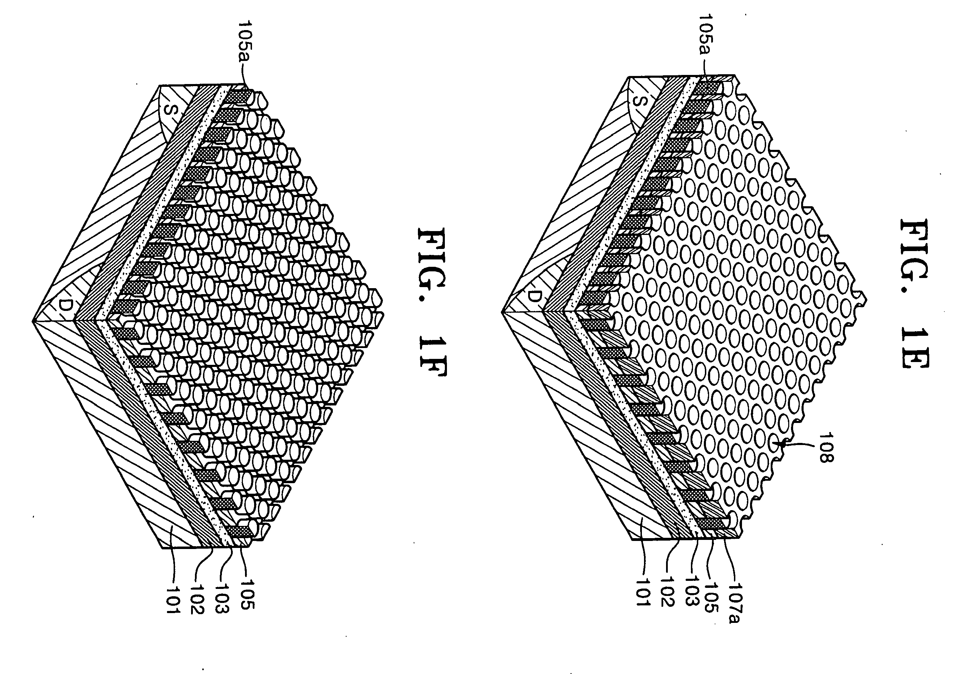

Referring to FIG. 1E, an oxide metal layer 107a having a plurality of holes 108 is formed by anodizing the metal layer 107 shown in FIG. 1D. During the anodization, portions of the sacrificial layer 105, which are exposed through the holes 108, are oxidized using an oxidant to be changed into an oxide sacrificial layer 105a, and grown to a certain degree in the holes 108. For example, if the metal layer 107 is formed of Al, the oxide metal layer 107a changes into an Al₂O₃ layer, and if the sacrificial layer 105 is formed of Ta, the oxide sacrificial layer 105a changes into a Ta₂O₅ layer. The holes 108, which are circular shaped, are formed in a dot array structure, e.g., a honeycomb structure, such that they are uniformly and densely arranged to maximize their surface areas.

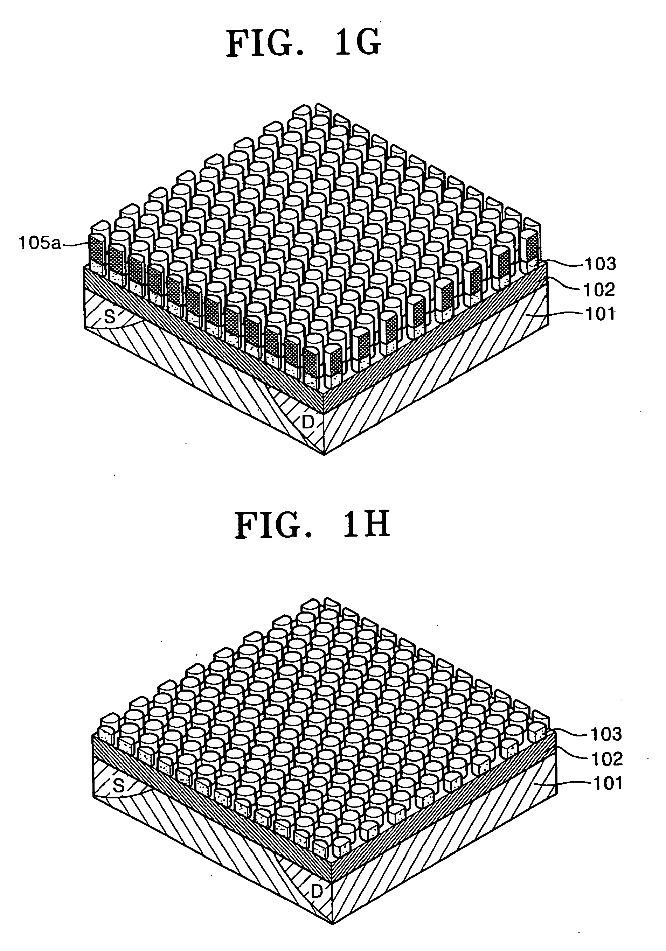

Next, referring to FIG. 1F, the oxide metal layer 107a is removed to entirely remain the sacrificial layer 105 and the oxide sacrificial layer 105a on the charge storage layer 103. Thereafter, portions of the sacrificial layer 105, which are exposed between the patterned oxide sacrificial layer 105a, and portions of the charge storage layer 103 below the portions of the sacrificial layer 105 are etched with the oxide sacrificial layer 105a as a mask, using ion milling or reactive ion etching (RIE). As a result, as shown in FIG. 1G, the charge storage layer 103 is patterned to have a nano dot array structure that is shaped like a honeycomb.

Next, the oxide sacrificial layer 105a on the charge storage layer 103 is etched to remain only the patterned charge storage layer 103 as shown in FIG. 1H. Then, a second insulating layer 109 is deposited on the charge storage layer 103 using CVD or sputtering.

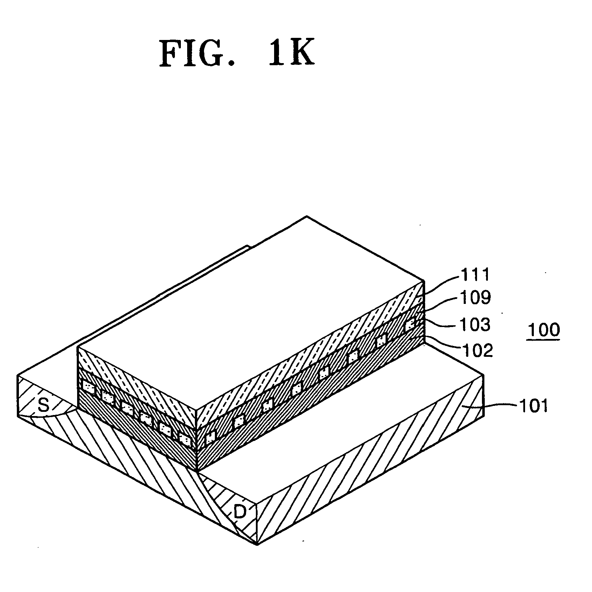

Next, as shown in FIG. 1J, a gate electrode 111 is deposited on the second insulating layer 109 and photolithography is performed on the resultant structure. In detail, a photosensitive material 42 is applied onto the gate electrode 111 and a mask 44 is placed over the photosensitive material 42. Next, when exposure, development, and etching are performed on the resultant structure, the first and second insulating layers 102 and 109, the charge storage layer 103, and the gate electrode 111 are patterned to a strip shape as shown in FIG. 1K. Here, the gate electrode 111 is formed of a conductive material such as polysilicon. When the processes explained with reference to FIGS. 1A through 1K are complete, a memory with nano dots is obtained.

A nonvolatile memory device, in which data can be electrically stored and erased and is not lost when power supply is discontinued, has various applications. For instance, flash memory and silicon-oxide-nitride-oxide-silicon (SONOS) memory are developed using nonvolatile memory devices. In general, flash memory has two types: a NOR type flash memory in which cells are arranged in parallel between a bit line and grounding; and a NAND type flash memory in which cells are arranged in series between a bit line and grounding.

A memory with nano dots according to the present invention can be embodied as flash memory by using the charge storage layer 103 as a floating gate. As the capacity of memory becomes larger and a circuit structure of memory becomes more complicated, the number of gate arrays required becomes larger and development of a finer patterning technique is required. Therefore, general stack gate type nonvolatile memory cells are being developed to become smaller and smaller but there is a limit to reduce their sizes using photolithography and etching. In this connection, a method of fabricating memory with nano dots according to the present invention makes it easy to manufacture a large capacity of nonvolatile flash memory without a high degree of skills such as photolithography and etching.

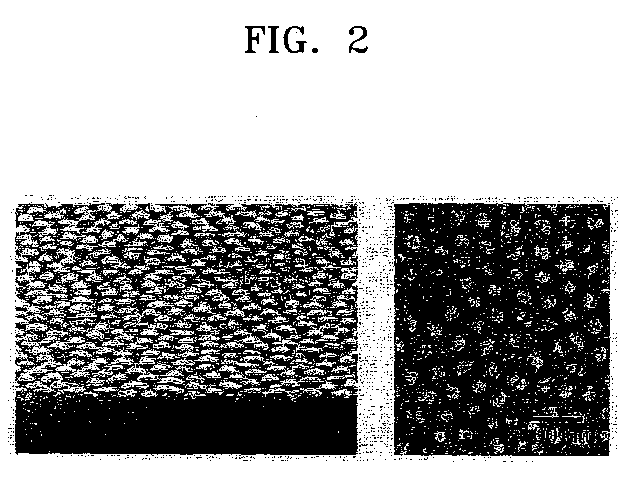

FIG. 2 is a photograph showing nano dots in memory, according to a preferred embodiment of the present invention, that are formed by etching the charge storage layer 103 of FIG. 1B using a nano-class Ta and Ta₂O₅ cylindrical structure as a mask, taken by a scanning electron microscope (SEM). Referring to FIG. 2, the nano dots having diameters of 20 - 25 nm and heights of 5 - 15 nm are uniformly distributed in the memory. However, the nano dots shown in FIG. 2 are illustrative of the present invention and the sizes of nano dots according to the present invention may be determined within a range from several nm to several dozen nm.

As described above, according to the present invention, it is possible to easily fabricate memory with nano dots by using a sacrificial layer, and self-alignment including anodic oxidation. Also, it is possible to make a large capacity of memory by uniformly distributing nano dots from several nm to several dozen nm. The smaller the size of a nano dot, the lower memory driving voltage, and the higher the performance of memory.

While this invention has been particularly shown and described with reference to preferred embodiments thereof, it will be understood by those skilled in the art that various changes in form and details may be made therein without departing from the scope of the invention as defined by the appended claims. For instance, those skilled in the art may make a charge storage layer using different materials having similar properties.

## Claims

1. A method of fabricating a charge-storage memory transistor having nano dots, comprising:
a. sequentially depositing a first insulating layer (102), a charge storage layer (103), a sacrificial layer (105), and a metal layer (107) on a substrate (101) in which source and drain electrodes are formed;
b. forming a plurality of holes (108) on the resultant structure by anodizing the metal layer (107) and oxidizing the sacrificial layer (105) which is exposed through the holes (108);
c. patterning the charge storage layer (103) to have nano dots by removing the oxidized metal layer (107a), etching the sacrificial layer (105) and the charge storage layer (103) using the oxidized sacrificial layer (105a) as a mask; and
d. removing the oxidized sacrificial layer (105a), depositing a second insulating layer (109) and a gate electrode (111) on the patterned charge storage layer (103), and patterning the first insulating layer (102), the charge storage layer (103), the second insulating layer (109), and the gate electrode (111) to a predetermined shape.

2. The method of claim 1, wherein the charge storage layer (103) is formed of a material selected from a group consisting of Si, Si₃N₄, and Al₂O₃.

3. The method of claim 1 or 2, wherein the sacrificial layer (105) is formed of Ta.

4. The method of any one of the preceding claims, wherein the metal layer (107) is formed of Al or Al alloy.

5. The method of any one of the preceding claims, wherein the first and second insulating layers (102, 109) are formed of Si₃N₄, and Al₂O₃.

6. The method of any one of the preceding claims, wherein during a., the first insulating layer (102), the charge storage layer (103), the sacrificial layer (105), the metal layer (107), and the second insulating layer (109) are deposited using chemical vapor deposition, sputtering, or evaporation.

7. The method of any one of the preceding claims, wherein during c., the charge storage layer (103) is patterned to have a dot array structure arranged as a plurality of cylinders.

8. The method of claim 7, wherein the cylinders are arranged to form a honeycomb structure.

## Patentansprüche

1. Verfahren zur Herstellung eines Ladungsspeicherungs-Speichertransistors mit Nanodots, umfassend:
a. sequentielles Abscheiden einer ersten Isolierschicht (102), einer Ladungsspeicherungsschicht (103), einer Opferschicht (105) und einer Metallschicht (107) auf einem Substrat (101), in dem Source- und Drain-Elektroden ausgebildet sind,
b. Ausbilden einer Mehrzahl von Löchern (108) auf der erhaltenen Struktur durch Anodisieren der Metallschicht (107) und Oxidieren der Opferschicht (105), die durch die Löcher (108) freigelegt ist,
c. Strukturieren der Ladungsspeicherungsschicht (103), so dass Nanodots entstehen, durch Entfernen der oxidierten Metallschicht (107a) und Ätzen der Opferschicht (105) und der Ladungsspeicherungsschicht (103) unter Verwendung der oxidierten Opferschicht (105a) als Maske und
d. Entfernen der oxidierten Opferschicht (105a), Abscheiden einer zweiten Isolierschicht (109) und einer Gate-Elektrode (111) auf der strukturierten Ladungsspeicherungsschicht (103) und Strukturieren der ersten Isolierschicht (102), der Ladungsspeicherungsschicht (103), der zweiten Isolierschicht (109) und der Gate-Elektrode (111) in eine vorgegebene Form.

2. Verfahren nach Anspruch 1, wobei die Ladungsspeicherungsschicht (103) aus einem Material ausgewählt aus der Gruppe bestehend aus Si, Si₃N₄ und Al₂O₃ gebildet wird.

3. Verfahren nach Anspruch 1 oder 2, wobei die Opferschicht (105) aus Ta gebildet wird.

4. VerFahren nach einem der vorhergehenden Ansprüche, wobei die Metallschicht (107) aus Al oder einer Al-Legierung gebildet wird.

5. Verfahren nach einem der vorhergehenden Ansprüche, wobei die erste und zweite Isolierschicht (102, 109) aus Si₃N₄ und Al₂O₃ gebildet werden.

6. Verfahren nach einem der vorhergehenden Ansprüche, wobei in Schritt a. die erste Isolierschicht (102), die Ladungsspeicherungsschicht (103), die Opferschicht (105), die Metallschicht (107) und die zweite Isolierschicht (109) unter Verwendung von chemischer Gasphasenalbscheidung, Sputtern oder Verdampfung abschieden wird.

7. Verfahren nach einem der vorhergehenden Ansprüche, wobei in Schritt c. die Ladungsspeicherungsschicht (103) so strukturiert wird, dass sie eine Dot-Array-Struktur aufweist, die als eine Mehrzahl von Zylindern angeordnet ist.

8. Verfahren nach Anspruch 7, wobei die Zylinder so angeordnet sind, dass sie eine Wabenstruktur bilden.

## Revendications

1. Procédé de fabrication d'un transistor de mémoire à stockage de charge comportant des nanopoints, consistant à :
a. déposer séquentiellement une première couche isolante (102), une couche de stockage de charge (103), une couche sacrificielle (105) et une couche de métal (107) sur un substrat (101) dans lequel des électrodes de source et de drain sont formées ;
b. former une pluralité de trous (108) sur la structure résultante par anodisation de la couche de métal (107) et par oxydation de la couche sacrificielle (105) qui est exposée à travers les trous (108) ;
c. dessiner la couche de stockage de charge (103) pour obtenir des nanopoints en retirant la couche de métal oxydée (107a), en gravant la couche sacrificielle (105) et la couche de stockage de charge (103) en utilisant la couche sacrificielle oxydée (105a) en tant que masque ; et
d. retirer la couche sacrificielle oxydée (105a), déposer une deuxième couche isolante (109) et une électrode de grille (111) sur la couche de stockage de charge (103) dessinée, et dessiner la première couche isolante (102), la couche de stockage de charge (103), la deuxième couche isolante (109) et l'électrode de grille (111) en une forme prédéterminée.

2. Procédé selon la revendication 1, dans lequel la couche de stockage de charge (103) est constituée d'un matériau sélectionné dans un groupe consistant en le Si, le Si₃N₄ et l'Al₂O₃.

3. Procédé selon la revendication 1 ou 2, dans lequel la couche sacrificielle (105) est constituée de Ta.

4. Procédé selon l'une quelconque des revendications précédentes, dans lequel la couche de métal (107) est constituée d'Al ou d'alliage d'Al.

5. Procédé selon l'une quelconque des revendications précédentes, dans lequel les première et deuxième couches isolantes (102, 109) sont constituées de Si₃N₄ et d'Al₂O₃.

6. Procédé selon l'une quelconque des revendications précédentes, dans lequel, à l'étape a., la première couche isolante (102), la couche de stockage de charge (103), la couche sacrificielle (105), la couche de métal (107) et la deuxième couche isolante (109) sont déposées en utilisant un dépôt, une pulvérisation ou une évaporation en phase vapeur.

7. Procédé selon l'une quelconque des revendications précédentes, dans lequel, à l'étape c., la couche de stockage de charge (103) est dessinée pour présenter une structure à réseau de points agencée commue une pluralité de cylindres.

8. Procédé selon la revendication 7, dans lequel les cylindres sont agencés pour former une structure en nid d'abeilles.
